(19) Europäisches Patentamt

European Patent Office

Office européen des brevets

(11) **EP 1 089 507 A2**

(12) **EUROPEAN PATENT APPLICATION**

(43) Date of publication:
**04.04.2001 Bulletin 2001/14**

(51) Int. Cl.⁷: **H04L 25/03**

(21) Application number: **00120446.0**

(22) Date of filing: **19.09.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.09.1999 IT MI992010**

(71) Applicant:
**Siemens Information and Communication Networks S.p.A.
20126 Milano (IT)**

(72) Inventors:
• **Rallo, Claudio
92100 Agrigento (IT)**
• **Raveglio, Dalmazio
20133 Milano (IT)**

(74) Representative: **Giustini, Delio
c/o Siemens Information and Communication Networks S.p.A.,
Cascina Castelletto
20019 Settimo Milanese (IT)**

(54) **Method for the calculation of the coefficients of a polyphase FIR filter**

(57) Object of the invention is a method for the calculation of coefficients of a FIR filter capable of simultaneously performing the two functions of band pass and equalization of the sinc(x) distortion generated by the DAC in the second spectral replica at intermediate frequency. The method can be applied with all those coefficient calculation algorithms optimizing the parameters of the response in frequency in order that it observes the different bands of a pre-set mask, such as for instance, that of the minimum quadratic error, or those based on the Chebyshev theory. In particular, the A constant magnitude band pass of the non equalized function $D(f)$ is subdivided into a high number of sub-bands and for each one of them the 1/sinc(x) function is calculated for x at the sub-band start and end frequencies. Therefore, said constant value A is multiplied by the two calculated values for each sub-band and the $D(f)$ function is replaced by a new function $D'(f)$ having straight trend between the pairs of values.

**Fig. 5**

EP 1 089 507 A2

## Description

### Field of the invention

The present invention relates to the field of radio transmissions of digitally modulated signals and more in particular to a method for the calculation of coefficients of a FIR (Finite Impulse Response) filter that integrates the interpolation, band pass and equalization of sinc(x) distortion functions, and to a polyphase architecture for the filter realisation.

### Background art

The more recent years have been marked by the passage to the digital technique in the implementation of radio telecommunication links and of equipment for mobile telecommunication, formerly in analogue technique. In the first digital transmitters of the multichannel type, the analogue portion was still prevailing, but afterwards with the development of ever quicker and accurate analogue-to-digital converters it has been possible to synthesize a multichannel digital signal directly at intermediate frequency IF. The present characteristic of such a digital signal is to have a bandwidth corresponding to an important fraction, or even to the whole band assigned to the particular radio communication service. As the digital technique progressed in the radio field the main functions of a transceiver could be governed via software through dedicated programs that, for instance, select the modulation type, and consequently reconfigure the channel filters, assign or re-assign the channels within the transmission band, determine amplification values, check synchronism and alarms, etc. The radio software term is a keyword purposely coined to define the above mentioned systems.

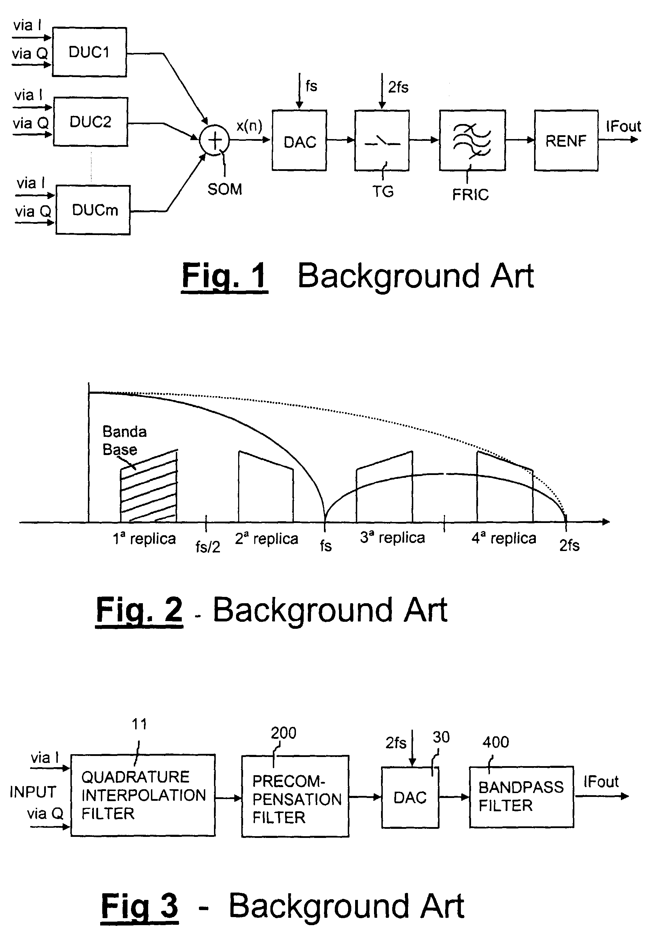

We shall now consider some transmission systems according to the background art, in order to highlight the different implementation methods of the relevant sections concerning the synthesis of the digital signal at intermediate frequency and the relevant conversion to analogue, immediately before the transfer at radio frequency. From the comparison the different advantages and problems still open will result clear. Reference figures for the known art are shown from fig. 1 to fig. 4.

Figure 1 shows a block diagram of the digital section and of the D/A conversion section of a broad band radio transmitter described in the international patent application No. PCT/EP98/04967. With reference to fig.1 we notice that the radio transmitter includes as many m DUC1, ....., DUCm blocks as are the m signals to transmit. Each DUC (Digital Up Converter) block is a modulator in quadrature (I, Q) performing also the frequency upward conversion of the modulated signal; to this purpose it includes a digital oscillator and a multiplier, digital it too, acting as mixer without generating spurious products. The frequencies of digital oscillators are assigned in such a way that frequency spectrum of the m channels result adjacent among them to form a single multichannel signal x(n) present at the output of a numeric adder SOM, which obtains said signal in the form of a sequence of numeric samples with fs interval. The x(n) signal is converted to analogue by a DAC block (Digital to Analogue Converter) and sent to a transmission gate TG, operated at frequency 2fs, and then to a band pass filter FRIC selecting the second replica in the repeating spectrum around the nfs frequencies present at the output of the DAC block. The filtered signal is then sent to an equalizer having RENF width, submitting the input signal to a variable amplification with frequency in a way reciprocal to that of the sinc(x) distortion in the band of the second replica, obtaining the equalized IFout signal at intermediate frequency. As it is known, the function

$$sinc(x) = \frac{sin\ x}{x}\ ,$$

where

$$x = \frac{2\pi f}{fs}\ ,$$

envelops the width of spectral replica present in the signal outgoing the DAC, showing periodical zeros at the points *nfs*. This function is shown with a continuous line in fig. 2.

The transmission gate TG performs on the analogue signal an operation similar to a digital interpolation obtained inserting a null sample every two adjacent samples having *1/2fs* duration. The result is also that to move the zeroes of the sinc(x) function to points 2nfs, thus sending away from the maximum attenuation area the second replica that shall be selected by the FRIC analogue filter. The new sinc(x) function is shown with a dashed line in fig.2. The RENF block is an emphasis analogue network recovering the residual 1,72 attenuation dB between the starting and the end of the spectrum of the second replica 10 MHz wide.

The scope of the known architecture of fig.1 was essentially that to send away from the continuous value the spectrum of the signal at IF in order to relax the realization of the image filter at radio frequency. The purpose is reached through operations concerning only analogue section at the output of the DAC block.

Fig.3 is a block diagram of the invention described in the European patent application EP 0817369 A2 filed by HARRIS CORPORATION under the title: "Method of up-converting and up-converter with pre-compensation filter". As it can be noticed, the digital section includes a DUC block 11, which in turn includes an interpolation filter, and includes also a filter 200 for the recovery of sinc(x) distortion in the selected band at the output of a DAC block 30. An analogue band pass reconstruction filter 400 placed in cascade to the DAC block operates the above-mentioned selection. Compared to the implementation of fig.1 we see that now the analogue part is reduced to only reconstruction band pass filter 400. This solution does not enable in practice, at equal band width of the IF signal with the first case prospected, to go beyond the selection of the second replica, since for the selection of an n-th replica it is necessary to multiply by nfs the operation speed of the DAC block 30, thus surpassing the limit set by the technology of said devices.

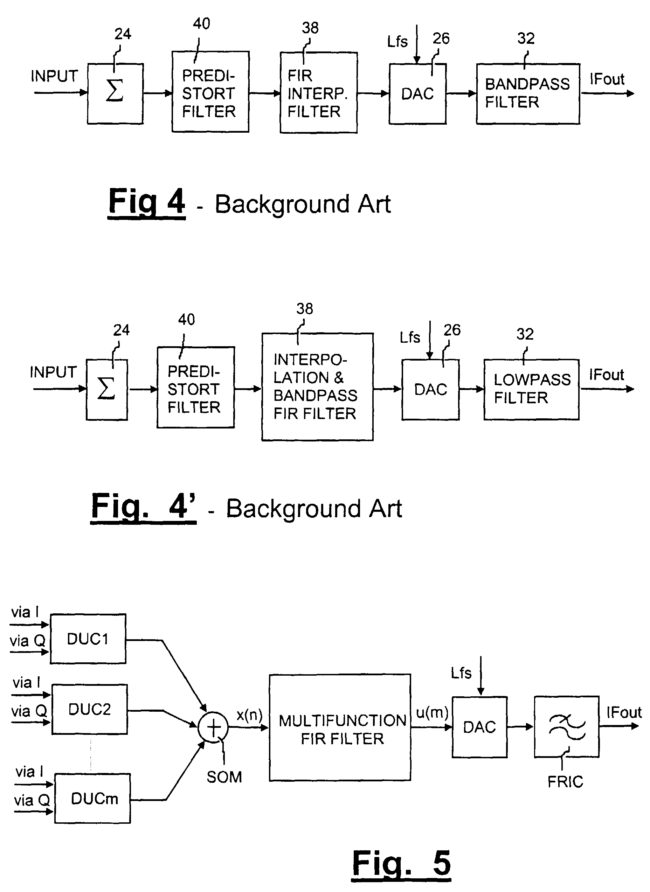

Fig. 4 is a partial diagram concerning a transmitter described in the European patent application EP 0534255 A2 filed by HUGHES AIRCRAFT COMPANY under the title: "Multiple use digital transmitter/transceiver with time multiplexing". Making reference to the figure, we notice the following blocks: a digital adder 24, a digital pre-distortion filter 40, a FIR interpolator filter 38, a DAC 26, and an analogue band pass filter 32 from which a signal at intermediate frequency IFout of the multichannel type comes out. As for the case of the preceding fig. 3 the pre-distortion digital filter 40 recovers the sinc(x) distortion on the replica that shall be selected for transmission. The text (in column 7, lines 1 to 15) relates that the FIR filter 38, performs an interpolation on the digital signal through insertion of zeros to generate images at upper frequencies, in this case the analogue band pass filter 32 selects one sole image for the transmission. In the same paragraph it is recounted that the image selection function can be otherwise performed by the same FIR filter 38, in this case the analogue filter 32 can be a simple low pass removing the residual images generated by the DAC block. This embodiment is shown in fig.4'. In the case of fig.4 the HUGHES solution does not differ from the Harris one of fig. 3, while in the case of fig.4' the difference is evident.

We can conclude on background art highlighting the fact that the HUGHES solution of the other embodiment of fig.4' involves, concerning the synthesis of the IFout signal, the maximum concentration of functions in the digital section. The aim is reached through a pre-distortion filter placed before a band pass filter, that is through two separate digital devices.

## Object of the invention

The present invention aims at obtaining the maximum functional compaction in the devices performing the digital processing of the signal transmitted by a multichannel transmitter, indicating a method for the calculation of coefficients of a FIR type digital filter capable of integrating in a unique calculation procedure the functions of band pass and equalisation of the sinc(x) distortion in the band of a spectral replica at intermediate frequency generated through digital interpolation; distortion otherwise present in the band of the signal at the output of the digital to analogue converter.

Further object of the present invention is to indicate particular polyphase networks for the implementation of the above-mentioned multifunction FIR filter, capable of reducing the number of delay elements and multipliers compared to the known forms.

## Summary of the invention

To attain these aims the present invention employs a method for the calculation of the coefficients of a FIR type digital filter for the selection of an m-th replica at intermediate frequency of the base band spectrum of an input signal digitally interpolated to the sampling frequency $fc = Lfs$, being $L$ the interpolation factor, the filtered signal being converted to analogue, reconstructed and transferred at radio frequency for transmission, as described in claim 1.

## Advantages of the invention

From the description of the method for the calculation of the coefficients described in claim 1, and more in detail in the example of one embodiment the invention, clearly appears as the functions of interpolation, band pass, and equalization of the sinc(x) distortion combine among them in order to confer to the method a unitary development including the equalisation in filtering without considerably increasing the computational complexity. Consequently it is possible to obtain a sole device easily integrating all the three above-mentioned functions, simplifying the project of the digital section. Contrarily to the approaches of the known art, where the separation of the two functions of equalisation and filtering forcedly involves the separate design of two different devices, the invention exploits the synergy coming from the inclusion of the two functions in a unique calculation method.

Profitably, the method for the calculation of the subject coefficients can be used with all those algorithms that optimize some parameters of the filter frequency response in order that it complies with the different zones of a pre-set mask, such as for instance the algorithms adopting the principle of the minimum quadratic error, or those based on the Chebyshev theory, which generate filters having an equiripple behaviour and minimize the maximum module of the error function evaluated in the extreme frequency points.

Additional computational advantages are obtained in the case the filter is at linear phase since it is possible to exploit the symmetry of coefficients. In this case the selection of a symmetry of coefficients characteristic of a filter of the third type, known as Hilbert transformer, proves to be profitable since the band pass filter shows infinite attenuation at null frequency and at Nyquist frequency.

We could also check that the equalization in pass band, at equal number N of coefficients, does not cause any attenuation reduction in stop band. Also concerning the width of the ripple in pass band we have no significant variations compared with the case of equalisation absence.

The selection of the second spectral replica by the digital band pass filter better fits to the speeds of presently available DACs.

In the realisation of a FIR filter, in the case of interpolation, it is possible to have recourse to canonical forms or polyphase networks. As it is well known, a polyphase network consists of $L$ branches $h_i(m)$ with $i=0,1,...,L-1$ in which the sequence of coefficients is obtained through sub-sampling of the original impulse response $h(n)$ with decimation factor $L$ and offset $i$. This characteristic can be used as opportunity to avoid the insertion of $L-1$ zeroes between two subsequent samples of a digitally interpolated input signal. In this case it is sufficient to cyclically switch with $f_s$ cadence, the input or output, of a generic branch of the network, towards the filter input, or output, respectively. It results a reduction of the number of multipliers.

The filter implementation having recourse to polyphase networks can in turn avail of known architectures, or it can profitably avail of innovative architectures that minimize the number of delay elements and of multipliers since they exploit the symmetry of the coefficients. Innovative architectures are described in two embodiments lightly different between them, the first one referred to the case in which the number of filter coefficients is N = 4k + 1 , while a second one to the case in which it is N = 4k - 1 ; both the cases being referred to an interpolation factor L = 2 for the selection of the second spectral replica.

Therefore, another object of the invention is a linear phase FIR filter, with odd coefficients and anti-symmetric versus the null central coefficient (known as linear phase digital filter of the third type), whose coefficients are calculated through the method described above, including a polyphase network whose input is reached by the samples of the incoming signal with $fs$ cadence and at whose output a digital switch cyclically withdraws the samples coming out from two output points with frequency $fc = 2fs$; the polyphase network including a number of multipliers corresponding only to one half minus one of the filter coefficients, the effect of missing coefficients being obtained through negation of the delayed samples which would have been multiplied by the anti-symmetric coefficients and adding the same to the starting samples to obtain new samples to send to the above mentioned multipliers; the outputs of the multipliers corresponding to even order coefficients being accumulated and sent to a first terminal of the digital switch, the outputs corresponding to odd coefficients being accumulated and sent to the second terminal of the same switch, as it results from two of the relevant appended claims.

Brief description of the figures

The present invention together with further objects and advantages thereof, may be understood with reference to the following detailed description, taken in conjunction with the accompanying drawings, in which:

- fig. 1 shows a block diagram of the part tasked of the synthesis of the signal at intermediate frequency IF of a multichannel transmitter scope of a precedent patent application in the name of the same Applicant;
- fig.2 shows the periodical frequency spectrum of the output signal at the output of a DAC block of fig.1, and overlapped is the shape of the envelope function sinc(x), in absence, and in presence, respectively of an interpolator block TG;
- figures 3, 4, and 4' show block diagrams similar to that in fig.1 but referred to other examples according to the known art;
- fig.5 shows a block diagram of the part tasked of the signal synthesis at intermediate frequency IF of a transmitter employing a multifunction digital filter implemented according to the method for the calculation of coefficients of the present invention;
- fig. 6a highlights a partial detail of the FIR MULTIFUNCTION block of fig.5 where, for convenience, the equalisation function has been excluded;
- figures 6b, 6c, 6d, 6e, 6f shows some frequency spectra at the input and output of the different blocks of fig.6a;

- fig.7 shows the distribution of normalized values of the N coefficients of the PBAND filter of fig.6a;
- fig.8 shows the zero-pole diagram in the complex plan of the PBAND filter of fig.6a;
- fig.9 shows the frequency response in module and phase of the PBAND filter of fig.6a;
- fig.10 indicates the frequency response in module and phase of the MULTIFUNCTION FIR filter of fig.5;
- fig.11 shows a detail of the frequency response in module and phase given in the previous fig.10, in which it is highlighted the equalization of the sinc(x) distortion obtained applying the method for the calculation of coefficients scope of the present invention;
- fig.12 is similar to fig.10, concerning the case in which the coefficients of the multifunction filter are expressed with a lower accuracy;
- fig.13 shows a polyphase network of the known type used for the implementation of the multifunction digital filter of fig.5;
- figures 14 and 15 show two oriented graphs representing the topology of a same number of new conception polyphase networks used for the implementation of the multifunction digital filter of fig.5; and
- fig.16 shows a polyphase network implemented using the oriented graph of fig.14.

Detailed description of some preferred embodiments

Comments to Figures 1 through 4 concerning the known art have already been made.

Making reference to fig.5 it can be noticed a battery of m DUC blocks converging in an adder SOM for the generation of a digital signal x(n) of multichannel type, similarly to what shown in fig.1. Contrarily to what occurs in the previous figures 1 to 4', the remaining part of the digital section includes now only one block denoted with the term "MULTIFUNCTION FIR FILTER" receiving at input the signal x(n) and whose output is directly connected to the input of a digital-to-analogue converter DAC. The samples of the x(n) signal consist of 14 bit words in fixed point format following one another with frequency fs = 34,666 MHz; the band width is limited between 3,666 and 13,666 MHz.

The signal outgoing the DAC block reaches a reconstruction low pass FRIC filter at the output of which the signal IFout at intermediate frequency is present, which shall be then transferred at radio frequency and additionally filtered for the suppression of the image generated by the mixer. Contrarily to the case of fig. 1, the operating frequency of the DAC block now is 2fs = 69,333 MHz.

As already said in the introduction, the multifunction FIR filter, shown in the figure with the block having the same name, performs the following digital operations on the x(n) signal: interpolation, band pass filtering for the selection of the second spectral replica, and equalization which would otherwise distress the IFout signal.

As far as equalization is concerned, the benefit of the interpolation on the equalization extent requested for the second replica can be seen in fig.1 from the comparison of the two trends of the sinc(x) function, with solid and dashed line, respectively. Also in the case of fig.5, as for the case of figures 1 and 2, the attenuation between the starting and the end of the spectrum of the second replica is only 1,72 dB. The small amplification amount requested to compensate such a distortion makes the equalisation made according to the equiripple approximation technique very accurate, as it occurs in the method described here after. The subject method integrates the three specified operations having recourse to known algorithms for the calculation of the FIR filter coefficients, being complex and universally proved procedures, adding however new phases concerning the equalisation of the sinc(x) distortion in the selected pass band. The new phases compel the optimization criteria contained in the known algorithms to carry out also the equalisation. Therefore it is completely evident how digital interpolation, filtering, and equalization operations interact among them melting together to emphasise the synergies.

A requisite of the transmission system employing the multifunction filter of fig.5 is that of phase linearity of the transmitted signal, consequently also the filters crossed by the signal shall have the same requisite. This is easily obtained employing FIR filters (Finite Impulse Response) with symmetric coefficients around a central point. Four types of linear phase FIR filters are known, generated by the possible combinations of the filter order, which can be even or odd, with the type of coefficient symmetry, it too even or odd. The order of a FIR filter corresponds to the degree of the polynomial that describes its impulse response; the number N of coefficients is equal to the filter order plus 1. The type of filter that better suits the needs of the system in which it is employed is the so called third type one, that is of even order and odd symmetry in coefficients, since (referring to the low pass with response at frequency normalized at the value of the Nyquist frequency fs/2) it shows infinite attenuation in the points denoted by f = 0 and f = 1. The phase linearity requirements represents a peculiarity of the transmission system but it does riot limit in any way the method for the calculation of the subject coefficients.

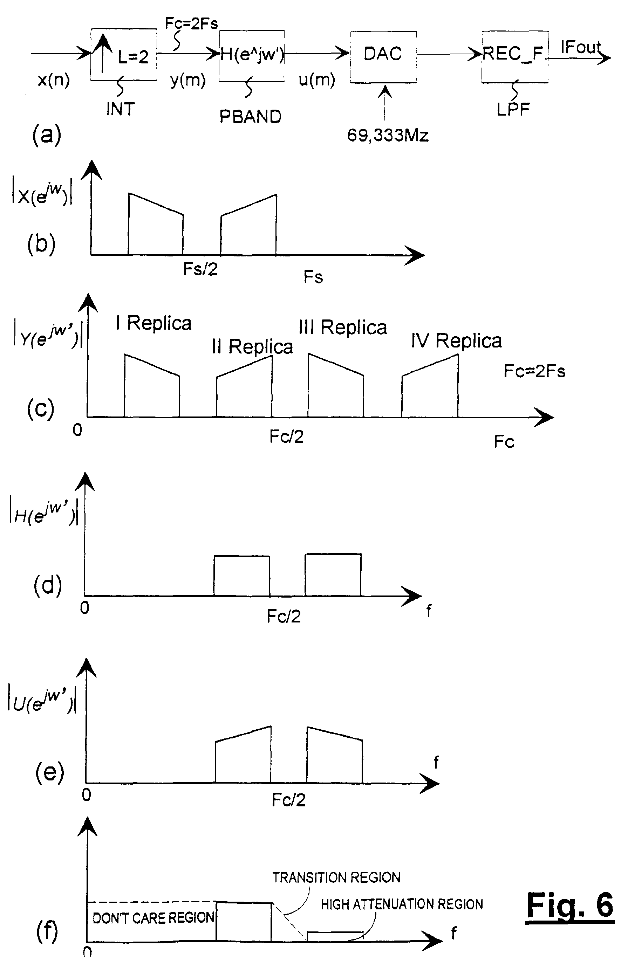

Fig 6a is useful to see the evolution of the spectral representation of signals in fig 5, extended up to the internal part of multifunction FIR filter. To this purpose it is convenient to temporarily leave apart the amplitude distortion equalisation function that envelops spectral replica. In the figure, the FIR is partially represented by an interpolator block INT having interpolation factor L = 2, with a filter band pass PBAND downstream. The interpolation is a known operation that, let L = 2, consists in doubling the sample frequency, maintaining the actual number through insertion of a zero between two consecutive samples. The new clock downstream the INT block is therefore fc = 2fs .

Fig. 6b shows the spectrum of the signal x(n) at the input of the interpolator block INT, said spectrum is indicated with the function $|X(e^{jw})|$.

Fig. 6c shows the spectrum of the signal y(m) at the output of the interpolator block INT and at the input of the filter PBAND, said spectrum is indicated with the function $|Y(e^{jw'})|$. As it can be noticed, the interpolation generates new replicas filling the space between fc/2 and fc.

Fig. 6d shows the mask of the filter PBAND in the assumption that the second replica is recovered. Fig. 6e shows the spectrum of the filtered signal u(m) reaching the input of the DAC block, said spectrum is indicated with the function $|U(e^{jw'})|$. The spectrum of the signal outgoing the block DAC contains the replicas of the spectrum $|U(e^{jw'})|$ around frequencies 2nfs generated by the conversion process to analogue. These replicas are removed from the low pass reconstruction filter FRIC. Fig. 6f shows the mask of filter FRIC.

The design of the band pass filter PBAND of fig.6a avails of the following specifications:

- sampling frequency of the input signal y(m): fc = 2×34,666 MHz = 69,333 MHz;
- pass band: 21 - 31 MHz, corresponding to the second replica;
- ripple in pass band: ± 0,25 dB;
- stop band first replica: 3,666 - 13,666 MHz;
- attenuation in stop band: 70 dB;
- phase: linear;
- non-defined bands are considered "don't care region".

As previously said, it is convenient to have recourse to a filter FIR of the third type (odd number N of anti-symmetric coefficients). Concerning the synthesis methodology of digital filters in general, and in particular of linear phase FIR filters, the following volume gives a valid teaching and wide bibliographic indications: "DIGITAL PROCESSING OF SIGNALS - THEORY AND PRACTICE", author Maurice Bellanger, published by JOHN WILEY & SONS Ltd., Copyright © 1984, translation of the volume by the same author under the title "Traitement Numérique du signal - Théorie Et Pratique". In this respect, the fifth chapter is the most pertinent one, which is incorporated for reference, in particular paragraph 5.2 and paragraphs 5.4 through 5.8. Paragraph 5.2 deals with transfer functions of linear phase FIRs; as it is known from the theory of the Fourier transform, or of other transforms that can be re-conducted to the same, the term transfer function is synonym of frequency response. The problem treated in paragraph 5.4 is that of the calculation of coefficients of a FIR (having phase not necessarily linear) according to the method of minimum quadratic error. The problem discussed in paragraph 5.5 is that of the calculation of the coefficients of a FIR having linear phase through iterations. Paragraph 5.6 gives a criterion to determine the number of coefficients. Paragraph 5.7 indicates realization networks for FIR filters; and finally in paragraph 5.8 the degradation of performances due to the finite arithmetic in the calculation of coefficients is evaluated.

The application of any synthesis method requires the preliminary knowledge of the number N of filter coefficients. Paragraph 5.6 gives the following formula useful to the purpose:

$$N = \tfrac{2}{3} \log\left(\frac{1}{10\delta_P\delta_S}\right) \frac{fs}{\Delta f} \qquad (5.32)$$

where $\Delta f$ is the minimum width of the transition band at the two sides of the band pass. The number so determined can be refined by attempts, that is applying the method for the calculation of coefficients with a lightly different higher or lower number of coefficients, and evaluating the effect on the filter response. Since coefficients are always calculated with high accuracy, it is possible for instance to avail of 64 bit floating point routines, while in practice the same are often expressed with arithmetic at 16 bit fixed point, it is necessary to increase by approximately 20 dB the attenuation in stop band to consider the worsening deriving in the filter operation performances. Keeping into account all the above mentioned considerations it was found that a filter having order 36, that is with 37 coefficients, enables to largely satisfy the specifications in stop band; on the contrary degradation in pass band is less critical due to finite arithmetic.

The solution of the problem described in paragraph 5.5 (iterations in the calculation of coefficients) implies the knowledge of the theory of the approximation of a given function, for instance the ideal frequency response D(f) of the filter, through a polynomial development. As it is already known, the development employing Chebyshev polynomials is, among all, the one that at equal attenuation accepted in pass band (ripple) shows the highest band width. Filters designed according to this criterion show equiripple behaviour in pass band and in stop band, for this reason the criterion optimising the approximation of the assigned curve minimizes the maximum error module within the concerned bands. It is possible to introduce a weight function

$$P_0 = \frac{\delta_P}{\delta_S}$$

enabling to diversify the ripple in pass band $\delta_P$ from that in stop band $\delta_S$. In the present case it was selected for $P_0$ a value of 170 that, for what we shall see below, enables a better approximation of the curve assigned in pass band.

Paragraph 5.2 of the mentioned volume indicates the following expression for the frequency response $H_R$ ($f$) of the subject linear phase FIR filter:

$$H_R(f) = \sum_{i=0}^{r-1} h_i sin(2\pi fiT) \qquad (5.30)$$

when the number of $h_i$ coefficients of the impulse response is $N = 2r - 1$. The technique given in paragraph 5.5 and shown below applies to all the cases, for even or odd N, and for symmetric or anti-symmetric coefficients. It is based on the following theorem indicated in the paper by T. W. Parks and J. H. MacClellan under the title: "Chebyshev approximations for Non Recursive Digital Filters with Linear Phase", published on the magazine IEEE Trans. Circuit Theory, CT19, 1972:

A condition necessary and sufficient because $H_R(f)$ is unique and represents the best approximation according to Chebyshev of an assigned function $D(f)$ above a compact sub-set $A$ of the interval $[0, \frac{1}{2}]$, is that the error function $e(f) = H_R(f) - D(f)$ shows at least $(r + 1)$ extremal frequencies on $A$. It means that there are $(r + 1)$ extremal frequencies$(f_0, f_1, ......, f_r)$ so that $e(f_i) = -e(f_{i-1})$ with $1 \le i \le r$ and:

$$\left| e\left(f_i\right) \right| = \max_{f \in A} \left| e\left(f\right) \right|.$$

This result is still valid if a weight function $P_0(f)$ of the error is introduced.

The problem arising goes back to the solution of the system of $(r + 1)$ equations:

$$P_0(f_i) [D(f_i) - H_R(f_i)] = (-1)^i \delta$$

where $\delta$ is the maximum value of the error function $e(f)$ and unknowns are the filter coefficients $h_i$ $(0 \le i \le r - 1)$. The system can be written in matrix form writing the unknowns in the form of a column vector and normalizing the frequencies in order that $fs = 1/T$:

$$\begin{bmatrix} D(f_0) \\ D(f_1) \\ \cdots \\ \cdots \\ \cdots \\ \cdots \\ D(f_r) \end{bmatrix} = \begin{bmatrix} 1 & sin(2\pi f_0) & \cdots & sin[2\pi f_0(r-1)] & \dfrac{1}{P_0(f_0)} \\ 1 & sin(2\pi f_1) & \cdots & sin[2\pi f_1(r-1)] & \dfrac{-1}{P_0(f_1)} \\ \cdots & \cdots & \cdots & \cdots & \cdots \\ \cdots & \cdots & \cdots & \cdots & \cdots \\ \cdots & \cdots & \cdots & \cdots & \cdots \\ \cdots & \cdots & \cdots & \cdots & \cdots \\ 1 & sin(2\pi f_r) & \cdots & sin[2\pi f_r(r-1)] & \dfrac{(-1)^r}{P_0(f_r)} \end{bmatrix} \begin{bmatrix} h_0 \\ h_1 \\ \cdots \\ \cdots \\ \cdots \\ h_{r-1} \\ \delta \end{bmatrix}$$

This matrix equation leads to the determination of filter coefficients provided that the ($r$ + 1) extremal frequencies $f_i$ are known.

To find the extremal frequencies an iterative procedure is used, based on an algorithm known as Remez exchange algorithm, in which each iteration includes the following phases:

- starting values are assigned or are already available, for parameters $f_i$ ($0 \le i \le r$);
- the corresponding value of $\delta$ is calculated solving the above mentioned equation system; this leads to the following formula:

$$\delta = \frac{a_0 D(f_0) + a_1 D(f_1) + \ldots a_r D(f_r)}{\dfrac{a_0}{P_0(f_0)} - \dfrac{a_1}{P_0(f_1)} + \ldots \dfrac{(-1)^r a_r}{P_0(f_r)}}$$

with:

$$a_k = \prod_{\substack{i=0 \\ l \ne k}}^{r} \frac{1}{sin(2\pi f_k) - sin(2\pi f_i)} \ ;$$

the values of the $H_R(f)$ function are interpolated between the $f_i$ ($0 \le i \le r$) in order to be able to calculate the error function $e(f)$ and find the stationary points corresponding to new values of extremal frequencies $f_i$. Due to the non-uniform distribution of extremal frequencies it is more convenient to use the Lagrange interpolation formula, from which it results:

$$H_R(f) = \frac{\sum_{k=0}^{r-1} \{\beta_k / (x - x_k)\}[D(f_k) - (-1)^k \delta / P_0(f_k)]}{\sum_{k=0}^{r-1} \beta_k / (x - x_k)}$$

with

$$\beta_k = \prod_{\substack{i=0 \\ 1 \neq k}}^{r-1} \frac{1}{x_k - x_i} \qquad \text{and} \qquad x = sin\left(2\pi f\right)$$

• frequencies obtained in the previous phase are taken as starting values for the next iteration.

Figure 5.15 of paragraph 5.5 of the mentioned volume, that we do not quote for shortness sake, shows the error evolution through an iteration. The figure clearly shows how the maximum error is compressed. The procedure is stopped when the difference between value δ calculated with the new extremal frequencies and the previous value drops under a set threshold. In the majority of cases the result is obtained after some iterations. The convergence of this procedure depends on the selection of the starting values for $f_i$ frequencies. For the first iteration an even distribution over the frequency range can be assumed.

On completion of iterations, the extremal final frequencies are used to produce a constant pace sampling of the frequency response $H_R(f)$, used in the discrete inverse Fourier transform to calculate $h_i$ coefficients of the filter without the need for a matrix inversion. This technique can be applied to filters having several hundreds of coefficients.

The paper by J. H. MacClellan, T. H. Parks and L. Rabiner, under the title: "FIR Linear Phase Filter Design Program", reported on the book IEEE Program for Digital Signal Processing, Chapter 5, published by John Wiley, New York, 1979, gives a computer program for the implementation of the method for the calculation of coefficients described above. This programme can be used for low pass, high pass, and band pass filters, with or without a fix initial phase shifting value. The different steps of the calculation are identified in the listing of the programme. The Parks-MacClellan algorithm has highly general valence and can be used for the project of not properly "classic" filters, for this reason it approximates the assigned function $D(f)$ dividing the frequency range between zero and the Nyquist frequency into a given number of disjoined sub-bands in which it is set the amplitude value desired for the frequency response of the filter one intends to design; in sub-bands, the magnitude can assume constant value or have a linear trend with the frequency. Between a sub-band and the next one there is a transition area or *don't care region* in which the width course is left free (the designer shall take care to check that also in these zones the frequency response observes the mask). Each sub-band is associated to a function $P_0(f)$ weighing the approximation error $e(f)$. If we want to apply the Parks-MacClellan algorithm to the project of a "classic" band pass filter, it is necessary to provide a unique sub-band corresponding to the pass band zone in which the assigned function $D(f)$ has constant magnitude, and two additional sub-bands corresponding to two lateral stop band zones in which the function $D(f)$ has attenuated magnitude. The trend in the two transition zones is not requested, since in said zones there are no extremal points of the error function. The subject method can also be applied to the mask of a low pass filter and therefore operate the transformation in band pass once the coefficients have been calculated; thus the function $D(f)$ results simplified.

The new conceived phases enable the method for the calculation of band pass coefficients to provide also to the recovery of the sinc(x) distortion in the band of the selected replica. The latter, without any limitation, corresponds in the case considered to the second spectral replica. To this purpose the pass band is subdivided in many adjacent sub-bands, possibly disjoined, even in the order of several hundreds, afterwards the constant magnitude of function $D(f)$ in the pass band zone, hereinafter defined A, is replaced by a straight trend $D'(f)$ joining the points in y axis (magnitude) at starting and ending frequencies of each sub-band, and between adjacent sub-bands whenever they are disjoined. The values in the above mentioned points of y axis are calculated multiplying said value A by the inverse of the sinc(x) function evaluated at the corresponding frequencies of sub-band start and end. In the case of the subject band pass filter the sinc(x) inverse function, due to the effect of the digital interpolation with interpolation index L = 2, becomes: $\frac{\pi f/2 fs}{sin(\pi f/2 fs)}$ where $x = \pi f / 2 fs$. Denoted $f_{1j}$ and $f_{2j}$ the starting and ending frequencies, respectively, of the *j*-th sub-band, the corresponding amplitude points $A_{1j}$ and $A_{2j}$ shall be respectively calculated as follows:

$$A_{1j} = A \frac{\pi f_{1j}/2 fs}{sin(\pi f_{1j}/2 fs)} \qquad \text{and} \qquad A_{2j} = A \frac{\pi f_{2j}/2 fs}{sin(\pi f_{2j}/2 fs)}$$

the straight line belonging to the $D'(f)$ function that approximates the ideal trend of the equalized function within the sub-band *j - th* has the following expression:

$$D'(f) = \frac{A_{2j} - A_{1j}}{f_{2j} - f_{1j}} f + \frac{A_{1j}(f_{2j} - f_{1j}) - f_{1j}(A_{2j} - A_{1j})}{f_{2j} - f_{1j}}$$

which is of the type $y = mx + p$. The same procedure can be used to construct the $D'(f)$ function between points belonging to two adjacent sub-bands should the same be disjoined. Operating in this way, the new method for the calculation of coefficients of the filter FIR obtains in the desired band a pre-distorted digital signal of an extent such for which, once the conversion to analogue has occurred, the inevitable distortion introduced in this phase is neutralised. It must be underlined the indissoluble connection of filtering with pre-distortion, contrarily to the methods of the known art.

Since in practice the trend of the ideal curve we want to approximate in pass band does not greatly deviate from the straight trend of function $D(f)$, equalization does not involve additional constraints to the morphology of the curve we want to approximate; so the filter order remains unchanged.

The newly conceived phases can well compete with the method of the minimum quadratic error described in paragraph 5.4. In this case the transition bands between the first and the second band at flat trend of the assigned function $D(f)$ have linear trend and are no more *don't care regions.* Moreover, a commonly used interpolation function is the following:

$$H(f) = \sum_{k=0}^{N-1} H_k \frac{sin\left[\pi N\left(\frac{f}{f_s} - \frac{k}{N}\right)\right]}{N sin\left[\pi\left(\frac{f}{f_s} - \frac{k}{N}\right)\right]} \qquad (5.23)$$

where the $H_k$ with ( $0 \leq k \leq N - 1$ ) are $N$ samples of the frequency response $H(f)$ of the FIR filter taken with period $f_s/N$. The above mentioned samples can be calculated with the following Fourier discrete transform applied to the set $h_i$ of samples of the impulse response, with ( $0 \leq i \leq N - 1$ ):

$$H_k = \frac{1}{N} \sum_{k=0}^{N-1} h_i e^{-j2\pi(ik/N)} \qquad (5.21)$$

On the other hand, coefficients of filter $h_i$ are tied to the set of samples $H_k$ from the following Fourier discrete inverse transform:

$$h_i = \frac{1}{N} \sum_{k=0}^{N-1} H_k e^{j2\pi(ik/N)} \qquad (5.22)$$

Consequently, the problem to calculate the $N$ coefficients is equivalent to that of determining the frequency response of the filter in $N$ points of the range $(0, f_s)$.

In the starting phase of the method the samples $H_k$ are not, of course, yet known; a first possibility is to select the $H_k$ sampling in $N$ equidistant points the function to approximate $D(f)$:

$$H_k = D\left(\frac{k}{N} f_s\right) \qquad by \qquad (0 \leq k \leq N\text{-}1)$$

The sampling concerns the band pass zone, the transition zone, and the stop band zones. Also in this case it is possible to apply the subject method to the mask of a low pass filter and therefore operate the transformation in band pass once the coefficients have been calculated; the $D(f)$ function so results simplified.

The transfer function $H(f)$ of the filter is obtained applying the interpolation function (5.23) to the set of values $H_k$ obtained at starting in this way.

Defined a weight function $P_0(f)$, the target function to minimize is the following:

$$E = \sum_{n=0}^{N_0-1} P_0^2(n)e^2(n) \qquad (5.24)$$

where $e(f) = H_R(f) - D(f)$ is the error function, and $N_0$ is the width of the sampling interval of the assigned function $D(f)$ expressed as number of samples($n$). Using the interpolation formula (5.23) to express $H(f)$ in the above-mentioned expression $e(n)$, the quadratic error function $e^2(n)$ results being a function of the set of values $H_k$ with $0 \leq k \leq N - 1$. In this case the target function (5.24) is a function of the $E(H)$ type. If starting samples $H_k$ are given an increase $\Delta H_k$ a new quadratic error $E(H+\Delta H)$ is obtained. The method we are describing is a direct method (that is not based on iterations) whose scope is to determine, through the solution of a system expressed in matrix form, the values of $\Delta H_k$ that transfers the starting values of samples $H_k$ in best values of the frequency response. The condition for which $E(H + \Delta H)$ is a minimum, is obtained nullifying the first and second derivative of $E(H + \Delta H)$ compared to $H_k$ values. The above mentioned derivatives can be organized in a matrix $A$ of $N$ lines and $N_0$ columns, whose elements are

$$a_{ij} = \frac{\partial e(j)}{\partial H_i}.$$

Leaving apart all the intermediate passages well known in literature, we come to the following matrix equation:

$$[\Delta H_k] = -[AP_0^2A^T]^{-1}\,AP_0^2\,[e(n)] \qquad (5.29)$$

where $[\Delta H_k]$ is a column vector whose elements are the unknown increases, and $P_0$ is a diagonal matrix of $N_0$ order whose elements are the weights $P_0(n)$. The solution of the (5.29) gives the searched increases. The following phases summarize the square least method:

1) sampling of the $D(f)$ function in order to obtain $N$ numbers $H_k$ with $0 \leq k \leq N -1$;
2) interpolation of the frequency response between the $H_k$ in the frequency band where the error shall be minimized, in order to obtain $N_0$ numbers $e(n)$ with $(0 \leq n \leq N_0 - 1)$ that represent the divergence between the filter frequency response and the function to approximate;
3) determination of $N_0$ weights $P_0(n)$ according to the constraints set to approximation;
4) calculation of the elements of matrix $A$ obtained employing the interpolation function (5.23);
5) solution of the system supplying the values of the vector elements $[\Delta H_k]$;
6) execution of the discrete Fourier inverse transform on the set of numbers $(H_k + \Delta H_k)$ with $0 \leq k \leq N - 1$ to obtain the filter coefficients.

Though the above mentioned calculations could appear complex they do not show nowadays particular difficulties. The drawback of this direct calculation method is that filters obtained have not constant width. This characteristic of filters is a quite recurring requirement that does not represent a problem applying the Parks-MacClellan recursive calculation method, previously described.

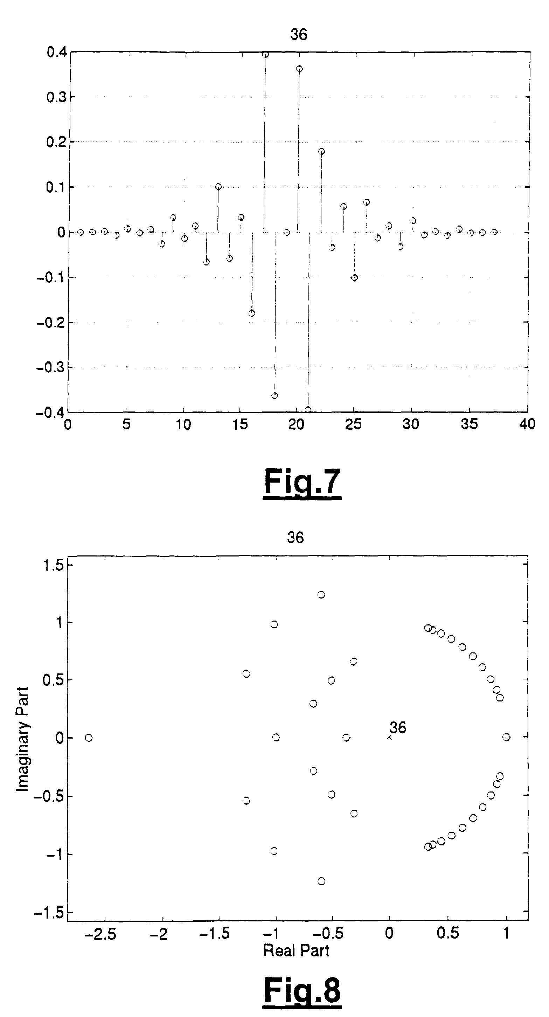

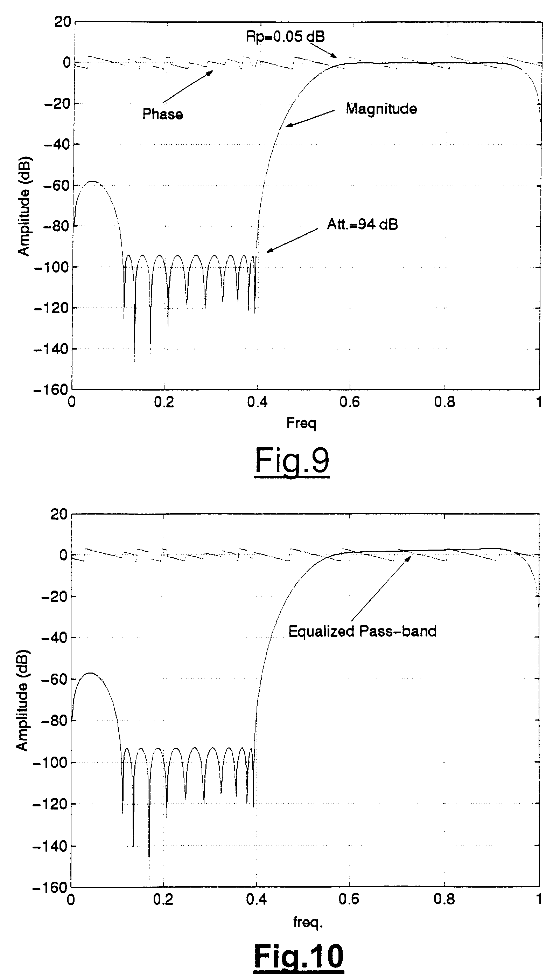

Figures 7, 8 and 9 are referred to the equiripple PBAND filter of the third type of fig.6a whose coefficients have been calculated employing the Parks-MacClellan algorithm. Fig. 7 shows the distribution of the 37 coefficients, anti symmetric versus the null central coefficient. Fig. 8 shows the diagram of poles and zeroes of the frequency response in the plan of the complex variable Z. In the figure, zeroes are indicated with a circle and poles with ×; as it can be noticed, being a FIR filter, 37 poles are concentrated in the origin. Fig. 9 shows the relevant frequency response in module and phase: it can be noticed the infinite attenuation at null frequency and at pass band limits. It can also be noticed that the equiripple behaviour, which due to the weight

$$P_0 = \frac{\delta_P}{\delta_S} = 170$$

is visible in stop band only. The attenuation in stop band is of approx. 20 dB higher than the specified one; the reason for this choice is determined by the fact that we wanted to keep a margin compared with the specification to consider the degradation introduced by the finite arithmetic used in the representation of coefficients.

Figures 10, 11 and 12 are referred to the filter of fig. 5 complete with equalisation in which the number of coefficients is unchanged versus the filter PBAND without the equalisation of previous figures 7, 8 and 9. The following table gives the values of the 37 coefficients of the filter with equalisation calculated with 64 bit floating point accuracy.

| Coefficient N° | Numeric value (floating point) |
|---|---|
| 1 | -5,924434 E-04 |
| 2 | 7,607729 E-04 |
| 3 | 2,011791 E-03 |
| 4 | -6,978202 E-03 |
| 5 | 6,608792 E-03 |
| 6 | -1,325229 E-03 |
| 7 | 6,035010 E-03 |
| 8 | -2,534643 E-02 |
| 9 | 3,183282 E-02 |
| 10 | -1,331861 E-02 |
| 11 | 1,394503 E-02 |
| 12 | -6,570095 E-02 |
| 13 | 1,014962 E-01 |
| 14 | -5,731424 E-02 |
| 15 | 3,333135 E-02 |
| 16 | -1,800021 E-01 |
| 17 | 3,948093 E-01 |
| 18 | -3,630507 E-01 |
| 19 | 0,000000 E+00 |
| 20 | 3,630507 E-01 |
| 21 | -3,948093 E-01 |
| 22 | 1,800021 E-01 |
| 23 | -3,333135 E-02 |
| 24 | 5,731424 E-02 |
| 25 | -1,014962 E-01 |
| 26 | 6,570095 E-02 |
| 27 | -1,394503 E-02 |
| 28 | 1,331861 E-02 |
| 29 | -3,183282 E-02 |
| 30 | 2,534643 E-02 |
| 31 | -6,035010 E-03 |
| 32 | 1,325229 E-03 |
| 33 | -6,608792 E-03 |
| 34 | 6,978202 E-03 |
| 35 | -2,011791 E-03 |

(continued)

| Coefficient N° | Numeric value (floating point) |
| --- | --- |
| 36 | -7,607729 E-04 |
| 37 | 5,924434 E-04 |

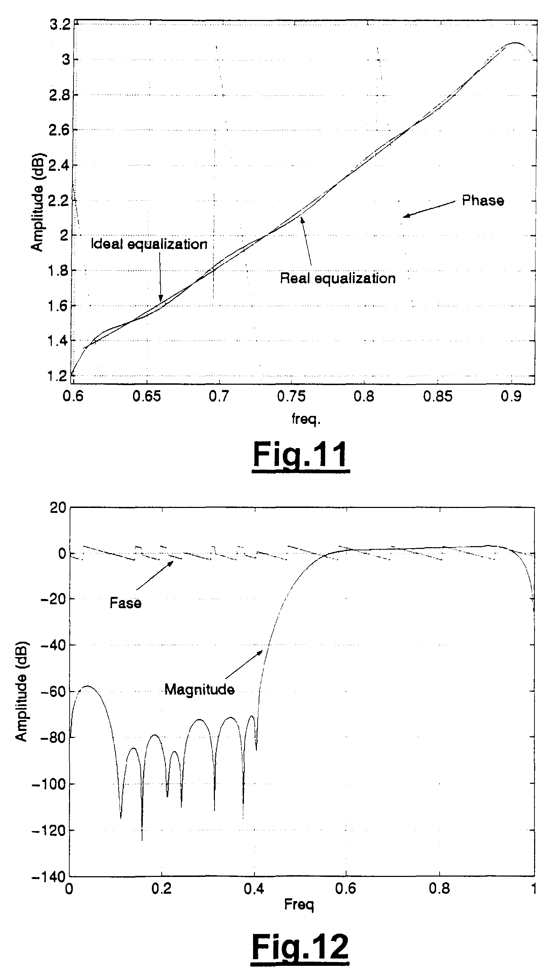

From fig.10 it can be noticed how equalization has not caused any attenuation decrease in stop band. The equalization extent is slightly perceivable in this figure; next fig.11 differs from fig.10 since it has a widened magnitude scale in correspondence with the pass band, in order to better highlighting the equalization effect. In the same figure it is compared the ideal curve with the actual one, which differs from the first one in an almost imperceptible manner.

Fig. 12 shows the worsening in the frequency response of the equalized FIR filter, compared with the response shown in fig.10, due to the representation of coefficients with 14 bit fixed point words. As it can be noticed, it is still possible to meet the specifications in stop band; in the pass band degradation results less critical. The 14 bit representation is purposely used to investigate on the limit of worsening due to the finite arithmetic; in the real case, coefficients have been represented with 16 bit fixed point words.

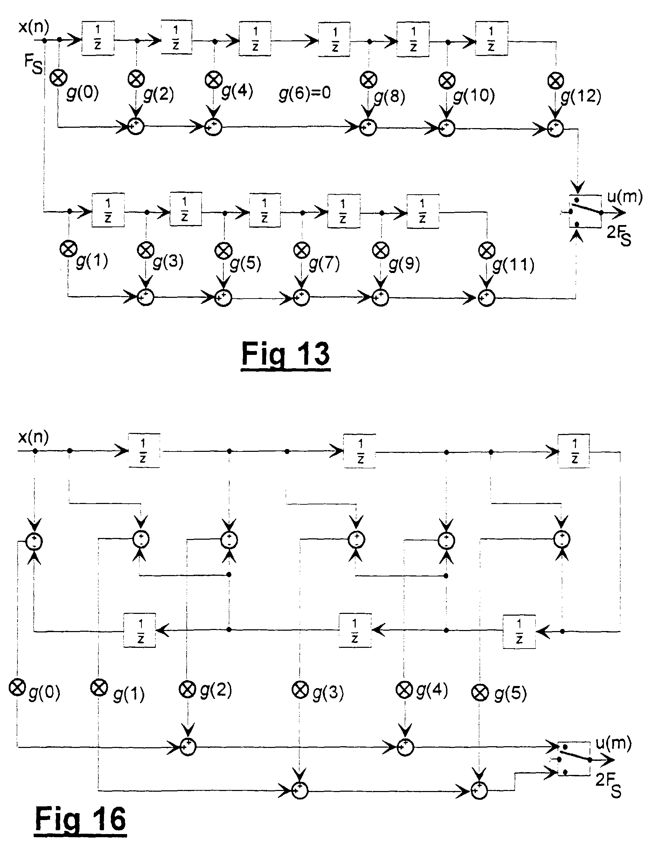

The embodiments of the multifunction digital filter of fig.5 are all shown in the relevant figures 13 to 16 through simplified structures of a FIR filter of the third type, employing a lower number of coefficients versus the real case, maintaining the same interpolation factor $L = 2$. The first simplified structures taken into consideration relate to a filter having a number of coefficients $N = 4k + 1$, with $k = 3$, and therefore $N = 13$. The second simplified structures considered, relate to a filter having a number of coefficients $N = 4k - 1$, with $k = 3$, and therefore $N = 11$. The extension of conclusions made in the case of the example of the 37 coefficient FIR filter, corresponding to a $N = 4k + 1$, with $k = 9$, shall result clear to the field technician.

Making reference to fig.13 we see a polyphase network with $N = 13$ coefficients, belonging to the known art, whose architecture is shown in the figure as extended architecture. The network consists of two filtering sections originating from a common input node reached by the samples of the signal to filter $x(n)$ with cadence $fs$, the two sections are connected at output to two relevant terminals of a digital switch withdrawing with frequency $2fs$ the signals alternatively coming from one or the other section to generate the samples of the filtered signal $u(m)$. Each section shows the canonical structure of a FIR filter that, as it is known, includes: sequential branches characterized by a relevant unit delay element $z^{-1}$ of the sample of the input signal crossing the single branch; multipliers of delayed samples by relevant filter coefficients; and adder elements of samples coming out from multipliers. One of the two sections of the polyphase network includes the multipliers for even order coefficients, that is: $g(0)$, $g(2)$, $g(4)$, $g(6)$, $g(8)$, $g(10)$, and $g(12)$, while the other section includes the multipliers for odd coefficients, that is: $g(1)$, $g(3)$, $g(5)$, $g(7)$, $g(9)$, and $g(11)$. Concerning FIR filters of the non-polyphase type, we see that in each FIR type filtering section of the polyphase network, the coefficients that multiply the samples separated by a unit delay $T = 1/fs$ of the input signal are now one every $L$.

The number of the polyphase network multipliers of fig.13 is $N-1 = 12$ and the number of adders is $N - 3 = 10$, since the multiplier for the null central coefficient $g(6)$ and the relevant adder is missing. Using product-accumulation elements, their number is $N - 3 = 10$; two additional multipliers for coefficients $g(0)$ and $g(1)$ shall also be required.

Similar considerations apply to the polyphase network with $N = 11$ coefficients. In this case the number of multipliers is $N - 1 = 10$ and the number of adders is $N - 3 = 8$. Employing the product-accumulation elements, their number is $N - 3 = 8$; two additional multipliers shall also be required.

In the operation, the polyphase network of fig.13 has the following transfer function:

$$H(z) = \sum_{\rho=0}^{L-1} z^{-\rho} P_\rho(z^L)$$

being: $p_\rho(n) = g(nL + \rho)$, with:

$$\begin{bmatrix} \rho = 0, 1, \ldots, L - 1 \\ n = 0, 1, \ldots, \dfrac{N-1}{L} \end{bmatrix}$$

and $L=2$
which in the discrete time domain generates the following signal $u$ at output:

$$\begin{bmatrix} u(2n) = x_1(n) \\ u(2n+1) = x_2(n) \end{bmatrix} \quad \text{where:} \quad \begin{bmatrix} x_1(n) = \sum_{k=0}^{\frac{N-1}{2}} p_0(k)\,x(n-k) \\ x_2(n) = \sum_{k=0}^{\frac{N-1}{2}} p_1(k)\,x(n-k) \end{bmatrix}$$

From the expressions of the output signal $u$ it can be noticed how the polyphase network does not require an adequate circuit for the insertion of a null sample between two samples of the input signal $x(n)$ and obtain the filtered signal $u(m)$ whose samples have double cadence. This characteristic of polyphase networks applies also to the networks shown in the following figures and enables to save the number of multipliers.

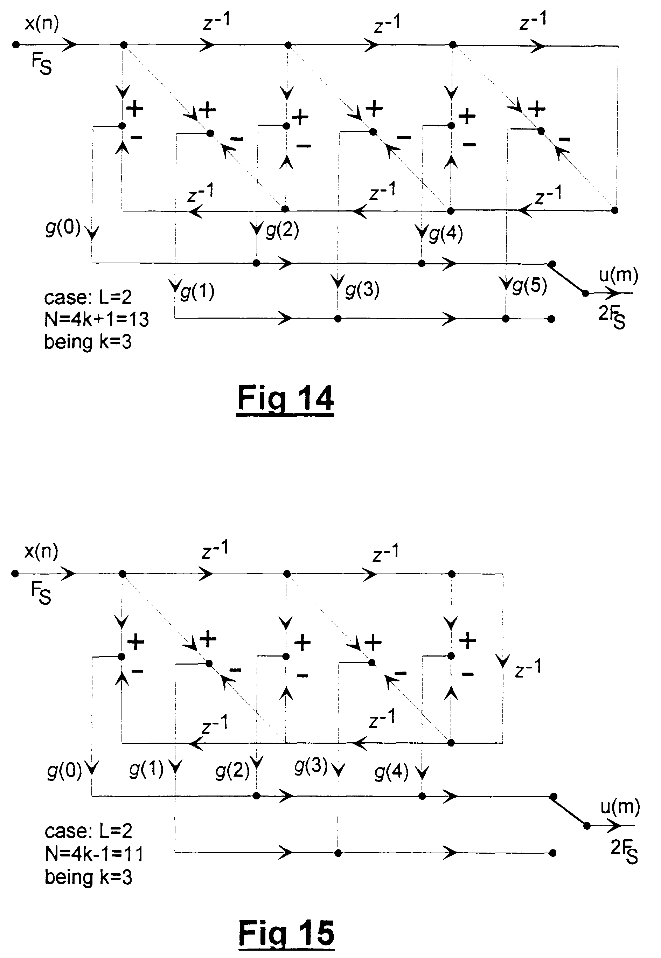

Fig. 14 shows an oriented graph that can be used for the implementation of a polyphase network expressing the same filter having $N = 13$ coefficients already scope of the polyphase network of fig.13 but showing novel characteristics. The associated architecture is shown in the figures as reduced architecture.

Fig.15 shows an oriented graph that can be used in the implementation of a polyphase network similar to that of fig.14 but with $N = 11$ coefficients.

Making reference to fig.14, it can be noticed that the graph consists of an upper section where interconnected meshes are indicated, and of a lower part including a set of sum nodes conveniently connected to the upper section through multiplication branches involved only in one half of the filter coefficients, and in particular: $g(0)$, $g(2)$, $g(4)$ and $g(1)$, $g(3)$, $g(5)$. The specified coefficients are those actually essential for the synthesis of the third order FIR filter, since the remaining ones can be obtained from the previous ones through sign inversion of the corresponding symmetric coefficients versus the null central coefficient.

More in particular, the architecture of the polyphase network of fig.16 directly deriving from the oriented graph of fig.14 (remembering that $N = 4k + 1$) includes:

- $\frac{N-1}{2}$ sequential branches including relevant unit delay elements ($z^{-1}$) at frequency $fs$ of the samples of the input signal $x(n)$ crossing the branches;
- $\frac{N-1}{2}$ adders arranged in succession and duly connected to the nodes limiting the branch ends, the adders having an actual and a negation input of the incoming signal;
- first branches starting from the first $\frac{N-1}{4}$ nodes connected to the two ends of each branch including a delay element and reaching the actual input of two consecutive adders;
- a second branch starting from the subsequent node $\frac{N+3}{4}$ and reaching the negate input of the last adder;
- third branches starting from the remaining nodes in progressive order, except for the last one coinciding with the negate input of the first adder, and reaching the negate input of two consecutive adders starting from the last but one up to the first one;
- $\frac{N-1}{2}$ multipliers of samples outgoing said adders by relevant coefficients belonging to the first half of the complete set of the filter coefficients;
- accumulation elements of samples coming out from multipliers multiplying by even order coefficients, connected among them and to a first terminal of a digital switch;
- accumulation elements of samples coming out from multipliers multiplying by odd order coefficients, connected among them and to a second terminal of the same digital switch cyclically switching the output, at a frequency double of the input samples one, between the two mentioned said terminals to generate samples of the filtered signal $u(m)$ digitally interpolated.

The polyphase network deriving from the oriented graph of fig.15 (for briefness, a figures has not been dedicated to the same) differs from that of fig.14 in the following:

- the first branches start from the first int [ $\frac{N-1}{4}$ ] nodes connected to the two ends of each branch including a delay element and reach the input of an actual input of two consecutive adders;
- the second branch starting from the subsequent node, reaches the actual input of the last adder.

Concerning the circuit economy in the two polyphase implementations, in the network of fig. 16 the number of multipliers is 6 and the number of adders is 10. Employing the product-accumulation elements, their number is 4; they shall also require 2 additional multipliers and 6 adders.

In the polyphase network of fig.15 the number of multipliers is 5 and the number of adders is 8. Employing the product-accumulation elements, their number is 3; they shall also require 2 additional multipliers and 5 adders. In both the cases, the cost saving versus the known architectures is evident.

**Claims**

1.  Method for the calculation of coefficients of a FIR type digital filter for the selection of an m-th replica at intermediate frequency of the base band spectrum of an input signal digitally interpolated at $fc = Lfs$ sampling frequency, being $L$ the interpolation factor, the filtered signal being converted to analogue, reconstructed and transferred at radio-frequency for transmission, said method including the following steps:

    a) constructing of a function $D(f)$ of the frequency showing a constant trend in magnitude within a first frequency band and a pre-set attenuation versus said constant trend in second frequency bands placed at the two sides of said first band, and separated by the same through transition zones having straight trend or complying with a mask;
    b) determining of the number $N$ of coefficients $g_i$ of the filter to synthesise through known criteria placing said number $N$ in direct proportion to the ratio between the frequency $fs$ of the samples of said input signal and the distance between said first frequency band $\Delta f$ of the function $D(f)$ and a second band, closer to the said first one;
    c) mathematical representing the frequency response $H_R(f)$ of said digital filter according to the unknown samples $h_i$ of the relevant impulse response, corresponding to coefficients $g_i$ of the filter to synthesise;
    d) assigning of a set of as many $N$ starting conditions as are the coefficients to calculate;
    e) interpolating of the trend of the frequency response $H_R(f)$ between successive samples $H_k$ of a set of samples obtained employing said starting conditions;
    f) determining of a weight $P_0(f)$ according to the limits set on the approximation of function $D(f)$ through the $H_R(f)$ function, used to multiply $k$ discrete values of an error function $e(f) = H_R(f) - D(f)$ measuring the deviation between said function $D(f)$ and said interpolated function $H_R(f)$;
    g) determining of a function $\delta(P_0(f_k) \times e(f_k))$ as target to minimize;
    h) minimizing of the target function employing minimization criteria obtaining the final samples $H_k$ of the interpolated frequency response $H_R(f)$;
    i) calculating of $g_i$ coefficients of the digital filter applying the discrete inverse Fourier transform to the set of final samples $H_k$ obtained at the previous step;
    **characterized in that** it includes also the following steps that come before said step a);

    -   subdividing of said first frequency band in which the function $D(f)$ has trend marked by a value of constant magnitude in a high number of adjacent sub-bands, possibly disjoined, even in the order of one thousand;
    -   multiplicating, for each sub-band, of said constant magnitude value by the $\frac{\pi f/fc}{sin(\pi f/fc)}$ function, evaluated at $f$ frequencies, from sub-band starting and end, respectively, obtaining couple of points with equalized magnitude;
    -   equalising of the frequency response $H_R(f)$ through replacement of said constant magnitude value of the function $D(f)$ by as many straight trends joining said points having equalized magnitude, obtaining a modified function $D'(f)$;
    -   replacing in said first frequency band of said assigned function $D(f)$ by the relevant function $D'(f)$ modified for the execution of the successive steps from a) to i).

2.  method for the calculation of coefficients according to claim 1, characterized in that the frequency response $H_R(f)$ of the digital filter mathematically represented in said step c) has the following expression:

$$H_R(f) = \sum_{i=0}^{r-1} h_i sin(2\pi fiT)$$

where the $h_i$ are said coefficients of the impulse response in number of $N=2r-1$ ;
and that the interpolation function used in said phase e) is the following:

$$H_R(f) = \frac{\sum_{k=0}^{r-1}\{\beta_k/(x-x_k)\}\left[D(f_k)-(-1)^k\,\delta/P_0(f_k)\right]}{\sum_{k=0}^{r-1}\beta_k/(x-x_k)}$$

with

$$\beta_k = \prod_{\substack{i=0\\i\neq k}}^{r-1}\frac{1}{x_k-x_i} \qquad \text{and} \qquad x = sin(2\pi f)$$

that generates width undulations in the interpolated function, called also ripples.

3. Method for the calculation of coefficients according to claim 2, characterized in that the weight function determined in step f) is the following:

$$P_0 = \frac{\delta_P}{\delta_S}$$

that enables to diversify the ripple in pass band $\delta_P$ from that in stop band $\delta_S$.

4. Method for the calculation of coefficients according to claim 3, characterized in that said target function determined in said step g) has the following expression:

$$P_0(f_i)[e(f_i)] = (-1)^i\delta$$

where

$$\delta = \left|e(f_i)\right| = \max_{f\in A}\left|e(f)\right|$$

calculated on $(r+1)$ extremal frequencies $(f_0, f_1,......, f_r)$ such for which $e(f_i) = - e(f_{i-1})$ con $1 \le i \le r$.

5. Method for the calculation of coefficients according to claim 4, characterized in that said target function $\delta$ generates the following system of $(r+1)$ equations:

$$\begin{bmatrix} D(f_0) \\ D(f_1) \\ \cdots \\ \cdots \\ \cdots \\ \cdots \\ D(f_r) \end{bmatrix} = \begin{bmatrix} 1 & sin(2\pi f_0) & \cdots & sin[2\pi f_0(r-1)] & \dfrac{1}{P_0(f_0)} \\ 1 & sin(2\pi f_1) & \cdots & sin[2\pi f_1(r-1)] & \dfrac{-1}{P_0(f_1)} \\ \cdots & \cdots & \cdots & \cdots & \cdots \\ \cdots & \cdots & \cdots & \cdots & \cdots \\ \cdots & \cdots & \cdots & \cdots & \cdots \\ \cdots & \cdots & \cdots & \cdots & \cdots \\ 1 & sin(2\pi f_r) & \cdots & sin[2\pi f_r(r-1)] & \dfrac{(-1)^r}{P_0(f_r)} \end{bmatrix} \begin{bmatrix} h_0 \\ h_1 \\ \cdots \\ \cdots \\ \cdots \\ h_{r-1} \\ \delta \end{bmatrix}$$

6. Method for the calculation of coefficients according to claim 5, characterized in that in said step d) arbitrary starting values are assigned to extremal frequencies $f_i$ with $(0 \leq i \leq r)$, and in said minimisation phase h) said system is used within an iterative procedure to calculate approximate values of the target function $\delta$ coinciding with the starting values of the extremal frequencies $f_i$ and of successive new values of the same, ending the iterations when the difference between two $\delta$ subsequent values falls under a pre-set threshold.

7. Method for the calculation of coefficients according to claim 6, characterized in that said approximate values of the target function $\delta$ are calculated through the following formula:

$$\delta = \frac{a_0 D(f_0) + a_1 D(f_1) + \dots \; a_r D(f_r)}{\dfrac{a_0}{P_0(f_0)} - \dfrac{a_1}{P_0(f_1)} + \dots \; \dfrac{(-1)^r a_r}{P_0(f_r)}}$$

with

$$a_k = \prod_{\substack{i=0 \\ i \neq k}}^{r} \frac{1}{sin(2\pi f_k) - sin(2\pi f_i)}.$$

8. Method for the calculation of coefficients according to claim 6, characterized in that said successive new values of the extremal frequencies $f_i$ are obtained interpolating, in said step e), the values of function $H_R(f)$ between the extremal frequencies $f_i$ $(0 \leq i \leq r)$ of the previous iteration, recalculating the error function $e(f)$ and searching the relevant steady points.

9. Method for the calculation of coefficients according to claim 1, characterized in that the frequency response $H_R(f)$ of the digital filter mathematically represented in said step c) has the following expression:

$$H_k = \frac{1}{N} \sum_{k=0}^{N-1} h_i e^{-j2\pi(ik/N)}$$

where the $H_k$, with $(0 \leq k \leq N - 1)$ are samples of $H_R(f)$ taken with period $f_s/N$; and in that the interpolation function used in said phase e) is the following:

$$H(f) = \sum_{k=0}^{N-1} H_k \frac{sin\left[\pi N\left(\frac{f}{f_s} - \frac{k}{N}\right)\right]}{N sin\left[\pi\left(\frac{f}{f_s} - \frac{k}{N}\right)\right]} \qquad (5.23)$$

where $H_k$ are $N$ samples of the frequency response of the FIR filter initially assigned in said phase d); said function generating width undulations in the interpolated function, called also ripples.

10. Method for the calculation of coefficients according to claim 9, characterized in that the weight function determined in step f) is the following:

$$P_0 = \frac{\delta_P}{\delta_S}$$

that enables to diversify the ripple in pass band $\delta_P$ from that in stop band $\delta_S$.

11. Method for the calculation of coefficients according to claim 10, characterized in that said target function determined in said step g) has the following expression:

$$E = \sum_{n=0}^{N_0-1} P_0^2(n) e^2(n)$$

where for the error determination $e(f) = H(f) - D(f)$ in said step f), said assigned function $D(f)$ is first sampled in said phase d) at constant pace $\Delta = \frac{f_s}{NL}$, with integer $L$ higher than 1, being $N_0$ the sampling interval width expressed as number of samples $(n)$.

12. Method for the calculation of coefficients according to claim 11, characterized in that the minimization of said target function $\delta$ in said step h) generates a system in matrix form that includes a matrix $A$ of $N$ lines and $N_0$ columns, whose elements are

$$a_{ij} = \frac{\partial e(j)}{\partial H_i} .$$

13. Method for the calculation of coefficients according to claim 12, characterized in that the solution of said system involves the solution of the following matrix equation:

$$[\Delta H_k] = -[A P_0^2 A^T]^{-1} A P_0^2 [e(n)]$$

where $[\Delta H_k]$ is a column vector whose elements are the unknown increases which said starting values $H_k$ are subject to, due to minimization; said increases transferring said starting values in the best values of the frequency response, and $P_0$ is an order $N_0$ diagonal matrix whose elements are weights $P_0(n)$.

14. Method for the calculation of coefficients according to claim 13, characterized in that said final samples $H_k$ of the frequency response $H_R(f)$ determined in said step h) are obtained summing up said starting samples obtained in said phase d) to said increases $\Delta H_k$ with $0 \leq k \leq N - 1$.

**15.** Method for the calculation of coefficients according to one of the previous claims, characterized in that said assigned function $D(f)$ corresponds to the mask of a low pass filter; and that a variation transforming said transfer function $H(f)$ in that of a band pass filter is operated on the filter coefficients thus calculated.

**16.** Method for the calculation of coefficients according to one of the previous claims, characterized in that said filter is a linear phase FIR filter.

**17.** linear phase FIR type digital filter, having $N = 4k + 1$ coefficients anti- symmetric versus the null central coefficient, **characterized in that** it includes:

- $\frac{N-1}{2}$ sequential branches including relevant unit delay elements ($z^{-1}$) at frequency $fs$ of the samples of the input signal $x(n)$ crossing the branches;
- $\frac{N-1}{2}$ adders arranged in succession and duly connected to the nodes limiting the ends of the branches, the adders having an actual input and a negation input of the incoming signal;
- first branches starting from the first $\frac{N-1}{4}$ nodes connected to the two ends of each branch including a delay element and reaching the actual input of two consecutive adders;
- a second branch starting from the subsequent node $\frac{N+3}{4}$ and reaching the negate input of the last adder;
- third branches starting from the remaining nodes in progressive order, except for the last one coinciding with the negate input of the first adder, and reaching the negate input of two consecutive adders starting from the last but one up to the first one;
- $\frac{N-1}{2}$ multipliers of samples outgoing said adders by relevant coefficients belonging to the first half of the complete set of the filter coefficients;
- accumulation elements of samples outgoing the multipliers by even order coefficients, connected among them and to a first terminal of a digital switch;
- accumulation elements of samples outgoing the multipliers by odd order coefficients, connected among them and to a second terminal of the same digital switch, cyclically switching the output, at frequency double of the input samples one, between the two said terminals to generate samples of the filtered signal $\mu(m)$ digitally interpolated.

**18.** linear phase FIR type digital filter, having $N = 4k - 1$ anti symmetric coefficients versus the null central coefficient, **characterized in that** it includes:

- $\frac{N-1}{2}$ sequential branches including relevant unit delay elements ($z^{-1}$) at frequency $fs$ of samples of the input signal $x(n)$ crossing the branches;
- $\frac{N-1}{2}$ adders arranged in succession and appropriately connected to the nodes delimiting the branch ends, the adders having an actual input and a negation input of the incoming signal;
- first branches starting from the first int $[\frac{N-1}{4}]$ nodes connected to the two ends of each branch including a delay element and reach the actual input of two consecutive adders;
- a second branch starting from the subsequent node and reached the actual input of the last adder;
- third branches starting from the remaining nodes in progressive order, except for the last one coinciding with the negate input of the first adder, and reach the negate input of two consecutive adders starting from the last but one up to the first one;
- $\frac{N-1}{2}$ multipliers of the samples coming out from said adders by relevant coefficients belonging to the first half of the complete set of the filter coefficients;
- storage elements of the samples coming out from the multipliers that multiply by the coefficients of even order, connected among them and to a first terminal of a digital switch;
- accumulation elements of samples outgoing the multipliers multiplying by odd order coefficients, connected among them and to a second terminal of the same digital switch cyclically switching the output, at frequency double of that of the input samples frequency, between the two said terminals to generate samples of the filtered signal $\mu(m)$ digitally interpolated.

**19.** Digital filter according to claim 17 or 18, characterized in that said multipliers and said accumulation elements are the product-accumulation elements.

## Fig. 1  Background Art

## Fig. 2 - Background Art

## Fig 3 - Background Art

**24**

INPUT → [Σ] → **40** [PREDI-STORT FILTER] → **38** [FIR INTERP. FILTER] → Lfs ↓ **26** [DAC] → **32** [BANDPASS FILTER] → IFout

# Fig 4 - Background Art

**24**

INPUT → [Σ] → **40** [PREDI-STORT FILTER] → **38** [INTERPO-LATION & BANDPASS FIR FILTER] → Lfs ↓ **26** [DAC] → **32** [LOWPASS FILTER] → IFout

# Fig. 4' - Background Art

via I →
via Q → [DUC1]

via I →
via Q → [DUC2]

via I →
via Q → [DUCm]

→ (+) SOM → x(n) → [MULTIFUNCTION FIR FILTER] → u(m) → Lfs ↓ [DAC] → [≈] → IFout
FRIC

# Fig. 5

**(a)**

x(n) → [↑ L=2] Fc=2Fs y(m) → [H(e^jw')] u(m) → [DAC] → [REC_F] IFout

INT

PBAND

69,333Mz

LPF

**(b)** $|X(e^{jw})|$

Fs/2    Fs

**(c)** $|Y(e^{jw'})|$

I Replica    II Replica    III Replica    IV Replica    Fc=2Fs

0    Fc/2    Fc

**(d)** $|H(e^{jw'})|$

0    Fc/2    f

**(e)** $|U(e^{jw'})|$

0    Fc/2    f

**(f)**

DON'T CARE REGION    TRANSITION REGION    HIGH ATTENUATION REGION

0    f

## Fig. 6

36

**Fig.7**

36

**Fig.8**

Fig.9

Fig.10

**Fig.11**

**Fig.12**

**Fig 13**

**Fig 16**

**Fig 14**

**Fig 15**